**Europäisches Patentamt**

**European Patent Office**

**Office européen des brevets**

(19)

(11) Numéro de publication: **0 246 951**
**A1**

(12)

# DEMANDE DE BREVET EUROPEEN

(21) Numéro de dépôt: **87401060.6**

(22) Date de dépôt: **11.05.87**

(51) Int. Cl.³: **H 01 L 35/08**
**G 01 J 5/12**

(30) Priorité: **16.05.86 FR 8607072**

(43) Date de publication de la demande:
**25.11.87 Bulletin 87/48**

(84) Etats contractants désignés:
**AT BE CH DE FR GB IT LI NL SE**

(71) Demandeur: **AGENCE NATIONALE DE VALORISATION DE LA RECHERCHE (A.N.V.A.R.) Etablissement public de droit français**
**43, rue de Caumartin**
**F-75436 Paris Cédex 09(FR)**

(72) Inventeur: **Thery, Pierre**
**45 Rue de Lille**
**F-59650 Villeneuve d'Ascq(FR)**

(72) Inventeur: **Leclercq, Didier**
**90 Rue Coustou**
**F-59800 Lille(FR)**

(72) Inventeur: **Hérin, Philippe**
**79 Route de Mons Bettignies**
**F-59600 Maubeuge(FR)**

(74) Mandataire: **Lecca, Jean et al,**
**CABINET PLASSERAUD 84, rue d'Amsterdam**
**F-75009 Paris(FR)**

(54) **Dispositif pour mesurer l'intensité d'un flux radiatif et éventuellement d'un flux convectif.**

(57) Le dispositif comprend un support mince (11) en une matière isolante; une bande continue mince (12a) méandriforme en une première matière conductrice; une série de dépôts discontinus (13a) en une seconde matière conductrice ayant un pouvoir thermoélectrique différent de celui de la première matière et une plus grande conductivité électrique, l'ensemble des depôts et de la portion associée de bande sous-jacente formant un thermocouple élémentaire et présentant, dans la direction transversale par rapport à la direction d'allongement (XX) de la bande, une largeur qui varie entre ses deux extrémités, la variation de largeur étant dans le même sens pour les dépôts successifs le long de la bande; et un revêtement (14) à forte émissivité recouvrant étroitement au moins les dépôts successifs. Le dispositif peut également comprendre une couche (15) conductrice de la chaleur.

FIG.3.

EP 0 246 951 A1

1

"DISPOSITIF POUR MESURER L'INTENSITE D'UN FLUX RADIATIF ET EVENTUELLEMENT D'UN FLUX CONVECTIF"

La présente invention concerne la mesure de l'intensité d'un flux radiatif, notamment d'un rayonnement thermique émis ou reçu par une surface ou paroi de manière à mesurer en particulier le flux net de chaleur perdu ou gagné par ladite surface ou paroi, et, éventuellement, d'un flux convectif.

On sait que les transferts radiatifs d'énergie jouent un rôle très important dans de nombreux mécanismes industriels, en particulier dans le chauffage des locaux.

Dans de tels mécanismes, le flux net $F_n$ de chaleur perdu ou gagné par une surface ou paroi est égal à la différence algébrique entre le flux radiatif $F_e$ qu'elle émet et le flux radiatif $F_a$ qu'elle absorbe : $F_n = F_e - F_a$.

Le flux net $F_n$ prend en compte l'ensemble des échanges radiatifs et il est positif si la surface ou paroi émet plus de radiations thermiques qu'elle n'en absorbe, tandis que $F_n$ est négatif si la surface ou paroi absorbe plus de radiations thermiques qu'elle n'en émet.

Si on veut maintenir constante la température d'une surface ou paroi il faut fournir à celle-ci une puissance thermique égale à $F_n$ si $F_n$ est positif, ou au contraire extraire de celle-ci une puissance thermique égale, en valeur absolue, à $F_n$ si $F_n$ est négatif.

En pratique, on mesure les échanges radiatifs entre deux surfaces ou parois, portées à des températures différentes $T_1$ et $T_2$, ou d'une surface ou paroi qui se trouve à une température $T_1$ et qui est soumise à une température radiante $T_2$ représentative des échanges radiatifs avec l'ensemble du milieu environnant.

Suivant le signe de la différence $T_1 - T_2$ un flux radiatif net est émis par la surface ou paroi à la température $T_1$ ou est reçu par celle-ci.

L'invention a précisément pour but de réaliser un dispositif pour mesurer l'intensité d'un flux radiatif émis ou reçu par une surface ou paroi, dispositif qui soit exact, précis et sensible, présente une constante de temps réduite et soit apte à être appliqué sur une surface ou paroi.

Généralement on mesure l'intensité d'un flux radiatif en convertissant ce flux radiatif en une différence de température dans un dispositif qui reçoit ce flux radiatif, qui convertit ce flux en une différence de température fonction de ce flux et qui mesure cette différence de température.

A cet effet on peut prévoir en particulier, de manière connue :

- une chaîne ininterrompue de deux types d'éléments thermoélectriques, de pouvoirs thermoélectriques différents, alternés et connectés en série, en formant donc une chaîne de couples thermoélectriques successifs avec une série de jonctions thermoélectriques entre deux éléments thermoélectriques successifs de pouvoirs thermoélectriques différents;

- deux types de revêtements disposés en alternance sur les jonctions thermoélectriques successives de la série de jonctions, les revêtements du premier type ayant un fort pouvoir absorbant (donc un pouvoir émissif $e_1$ élevé), tandis que les revêtements du second type ont un fort pouvoir réfléchissant (donc un pouvoir émissif $e_2$ faible), vis-à-vis du flux radiatif F à mesurer, de manière à convertir le flux radiatif en différence de température entre deux jonctions thermoélectriques successives, en créant des sources chaudes au niveau des jonctions recouvertes de revêtements du premier type et des sources froides au niveau des jonctions alternées recouvertes de revêtements du second type, les sources chaudes recevant une énergie thermique proportionnelle à $e_1F$ et les sources froides une énergie thermique proportionnelle à $e_2F$, la différence de

température entre une source chaude et une source froide voisine étant proportionnelle à l'intensité dudit flux radiatif F; et

- des moyens pour mesurer la somme des forces électromotrices (f.e.m.) élémentaires produites par les couples thermoélectriques élémentaires connectés en série et constitués chacun par une paire d'éléments thermoélectriques successifs de pouvoirs thermoélectriques différents et comportant une telle source chaude et une telle source froide, chaque f.e.m. élémentaire étant représentative de ladite différence de température et donc de l'intensité dudit flux radiatif.

Un tel dispositif est décrit par exemple dans le brevet des Etats-Unis n° 3.267.727 délivré le 23 août 1966 à Monsieur Theodor H. Benzinger.

Dans le dispositif selon ce brevet il y a modulation du flux radiant incident par l'émissivité variable spatialement (forte pour les revêtements du premier type, mais faible pour les revêtements du second type) et cette variation spatiale des échanges radiatifs provoque une variation de la température de surface dans la chaîne de thermocouples élémentaires connectés en série, en créant des sources chaudes et des sources froides alternées au niveau des revêtements à émissivités différentes.

Un tel dispositif présente une sensibilité relativement réduite, de l'ordre de 100 µV par watt de flux radiatif reçu et par $dm^2$ de surface exposée au flux radiatif.

Pour augmenter la sensibilité de ce type de détecteur de flux radiatif il y a intérêt à accroître la différence de température entre les sources chaudes et les sources froides, notamment en mettant en oeuvre un écart d'émissivité aussi important que possible entre les deux types de revêtements (du premier et du second type respectivement). On pourrait également penser à disposer une épaisseur suffisante d'une feuille plastique isolante

4

entre la thermopile et son support pour accroître ladite différence de température.

Mais un tel accroissement de la différence de température présente des inconvénients. En effet les écarts de température entre les sources chaudes et les sources froides tendent à produire des échanges thermiques convectifs entre ces deux espèces de sources, ces échanges convectifs (qui sont d'autant plus importants que la différence de température entre les sources chaudes et les sources froides est grande) engendrant à leur tour des variations de température de surface, avec pour résultat que chaque thermocouple élémentaires précité est soumis entre sa source chaude et sa source froide, non plus seulement à la différence de température (qu'il serait nécessaire de déterminer) résultant du flux radiatif à mesurer, mais à une différence de température résultant à la fois de ce flux et des échanges convectifs précités; de ce fait la différence de température entre chaque source chaude et chaque source froide n'est plus exactement proportionnelle au flux radiatif et il en est de même de la f.e.m. élémentaire engendrée par chaque thermocouple. De ce fait la somme des f.e.m. élémentaires connectées en série n'est plus une mesure exacte du flux radiatif que l'on désire déterminer. En outre il faudrait également prendre en compte les échanges convectifs beaucoup plus importants (produit par ventilation par exemple) qui existent dans le milieu où l'on effectue la mesure de flux radiatif.

Pour pallier ces inconvénients l'invention propose de transformer directement en tension électrique le flux radiatif à mesurer, sans passer par l'intermédiaire d'une différence de température, de façon à accroître la sensibilité et réduire les perturbations, exposées ci-dessus, dues aux échanges thermiques convectifs.

A cet effet, tout en mettant en oeuvre une chaîne d'éléments thermoélectriques ou couples thermoélectriques élémentaires connectés en série, chaîne constituée par une

bande continue en une première matière conductrice recouverte de place en place par des dépôts discontinus en une seconde matière conductrice ayant un pouvoir thermoélectrique différent de celui de la première matière et une conductivité électrique plus grande

- on déséquilibre par construction, dans la direction longitudinale de la chaîne de couples thermoélectriques, chaque couple thermoélectrique, en réalisant dans cette direction longitudinale, une variation spatiale de la largeur de la chaîne d'éléments thermoélectriques, à savoir la largeur de la bande continue et/ou des dépôts, afin de rendre dissymétriques les lignes de flux thermique dans le plan de cette bande;

- on dispose cette bande sur un support mince en une substance isolante;

- on recouvre au moins lesdits dépôts d'un revêtement de forte émissivité, afin que la transformation du flux radiatif en chaleur localisée dans ce revêtement de forte émissivité provoque des transferts thermiques tangentiels dissymétriques dans la chaîne d'éléments thermoélectriques à cause de la présence du dépôt électrolytique de grande conductivité thermique; et

- on mesure la force électromotrice disponible entre les deux extrémités de cette bande continue, cette force électromotrice étant proportionnelle à la déviation des lignes de flux thermique et donc au flux radiatif qui atteint ledit revêtement.

La présente invention a donc pour objet un dispositif pour mesurer l'intensité d'un flux radiatif comportant en combinaison :

- un support mince en une matière isolante;

- une bande continue allongée mince, en une première matière conductrice, l'une de ses faces étant fixée sur ledit support;

- une série de dépôts discontinus, en une seconde matière conductrice, disposés successivement, dans la direction d'allongement de ladite bande, sur l'autre face de celle-ci, cette seconde matière conductrice ayant un pouvoir thermoélectrique différent de celui de la première matière conductrice et une plus grande conductivité électrique et ces dépôts étant plus minces que ladite bande; et

- des moyens pour déterminer la force électromotrice disponible aux extrémités de ladite bande continue allongée;

et étant caractérisé

- en ce que l'ensemble, constitué par un desdits dépôts et la portion associée de la bande continue sous-jacente formant un thermocouple élémentaire, présente, dans la direction transversale par rapport à la direction d'allongement de ladite bande, une largeur qui varie entre ses deux extrémités, dans la direction d'allongement de ladite bande, la variation de largeur étant dans le même sens pour les dépôts se succédant le long de ladite bande; et

- en ce qu'il comporte un revêtement à forte émissivité recouvrant étroitement au moins lesdits dépôts successifs.

Cette variation de largeur de l'ensemble précité dépôt-portion associée de bande peut être réalisée

- en faisant varier la largeur du dépôt

- en faisant varier la largeur de la portion de bande

- en faisant varier la largeur du dépôt et de la portion de bande

- en prévoyant au moins un trou ou évidement qui découpe transversalement le dépôt et la portion de bande, le trou ou évidement étant toujours décalé dans le même sens, en direction longitudinale de la bande, par rapport au centre des dépôts; notamment ce trou ou évidement est ménagé à partir d'une extrémité (toujours dans le même sens en direction d'allongement de la bande) de chaque dépôt.

A titre d'exemple, la différence de largeur, dans la direction transversale, des dépôts et éventuellement de la bande continue, qui provoque la dissymétrie des lignes de flux thermique tangentiel peut être obtenue en donnant, à chaque dépôt et éventuellement à la portion de bande adjacente, une variation spatiale en forme de triangle isocèle (ou à la limite équilatéral), de trapèze isocèle, d'un T ou d'un U, l'axe de symétrie du triangle isocèle, du trapèze, du T ou du U étant aligné sur l'axe d'allongement de la bande et le sommet du triangle isocèle, qui est disposé sur cet axe, la petite base du trapèze, la barre du T ou l'ouverture de l'U étant dirigé dans le même sens si on considère la direction d'allongement de la bande.

Dans un premier type de modes de réalisation, le dispositif comporte un revêtement à forte émissivité recouvrant étroitement à la fois lesdits dépôts et les zones de la bande continue non revêtues de dépôts.

Ce revêtement à forte émissivité peut être lui-même recouvert d'une structure du type "nid d'abeilles" empêchant une circulation tangentielle de l'air au-dessus de la surface du revêtement.

Dans un second type de modes de réalisation, le dispositif comporte un revêtement à forte émissivité couvrant uniquement lesdits dépôts.

Dans ce second type de modes de réalisation, le dispositif peut avantageusement comporter en outre un revêtement réfléchissant, c'est-à-dire à faible émissivité, sur les zones de la bande continue non revêtues de dépôts.

Dans les modes de réalisation préférés la bande continue est avantageusement repliée pour avoir une configuration méandriforme.

La première matière conductrice formant la bande continue est par exemple l'alliage appelé "constantan", la seconde matière conductrice formant les dépôts est par exemple du cuivre et la matière isolante formant le support est par exemple la matière plastique du type polyimide dénommée "kapton".

Quant au revêtement à forte émissivité (voisine de 1), il peut être constitué par une peinture mate noire, par exemple du type platine ou du type or appelé "black gold", ou (notamment lorsque les dépôts sont seuls recouverts d'un revêtement à haute émissivité) par une pellicule d'oxyde de cuivre noir sur les dépôts lorsqu'ils sont en cuivre, cette pellicule étant obtenue par exemple par oxydation superficielle du cuivre des dépôts en portant ceux-ci à haute température dans une atmosphère oxydante.

Les revêtements à faible émissivité (voisine par exemple de 0,1) peuvent être réalisés par une pellicule d'aluminium ou une peinture à l'aluminium.

Lorsque le dispositif selon l'invention doit être appliqué sur une surface ou paroi, il peut être avantageux de recouvrir la face du dispositif à appliquer sur la surface ou paroi d'une couche en une matière très bonne conductrice de la chaleur, telle que le cuivre, pour réaliser une température uniforme moyenne sur cette face à l'échelle des couples thermoélectriques élémentaires.

On peut, afin d'accroître la sensibilité, doubler le dispositif selon l'invention en disposant contre chaque face du support une bande continue revêtue de dépôts avec le revêtement à fort pouvoir émissif sur au moins les dépôts.

Dans ce cas, on prévoit avantageusement un support supplémentaire, également en une matière isolante, qui est appliquée contre une des faces du dispositif double face, à savoir celle qui doit être appliquée contre une surface ou paroi, alors que l'autre face reçoit le flux radiatif à mesurer. Alors la couche conductrice de la chaleur, par exemple en cuivre, est déposée sur la face du support supplémentaire qui n'est pas contre la partie active du dispositif.

Avantageusement, on peut réaliser une compensation parfaite des échanges thermiques convectifs en associant deux fluxmètres radiatifs selon l'invention ayant exactement la même structure géométrique pour leur bande continue et leurs dépôts, mais étant recouverts de revêtements d'émissivités différentes, l'un des deux fluxmètres pouvant même ne pas comporter un tel revêtement, afin de transformer des quantités différentes de flux radiatif en flux thermique tangentiel alors qu'ils sont soumis aux mêmes échanges convectifs en provenance du milieu ambiant. La différence entre les résultats de mesure des deux fluxmètres soumis tous deux aux mêmes échanges convectifs fait apparaître la mesure du seul flux radiatif, les effets des échanges thermiques convectifs étant identiques dans les deux fluxmètres et disparaissant donc dans cette différence.

On peut ainsi disposer les deux fluxmètres (avec une même configuration géométrique en ce qui concerne la bande continue et les dépôts sur une même face d'un support en matière isolante, les bandes continues, avec les dépôts, des deux fluxmètres étant imbriquées l'une dans l'autre.

En variante, les deux fluxmètres peuvent être constitués à partir d'une bande continue commune revêtue de dépôts alternés appartenant respectivement au premier et au second fluxmètre, les dépôts couverts d'un revêtement à forte émissivité d'un des fluxmètres alternant avec les dépôts sans un tel revêtement du fluxmètre thermique et les deux types de dépôts alternés étant orientés en sens inverse en ce qui concerne la variation de la largeur, lorsqu'on considère la direction d'allongement de la bande continue commune.

En fait le fluxmètre comportant le revêtement le moins émissif, ou pas de revêtement du tout, constitue essentiellement un fluxmètre thermique de compensation (surtout lorsqu'il ne comporte pas de revêtement) permettant d'éliminer de la mesure différentielle globale les échanges thermiques convectifs.

L'invention pourra, de toute façon, être bien comprise à l'aide du complément de description qui suit, ainsi que des dessins ci-annexés, lesquels complément et dessins sont, bien entendu, donnés surtout à titre d'indication.

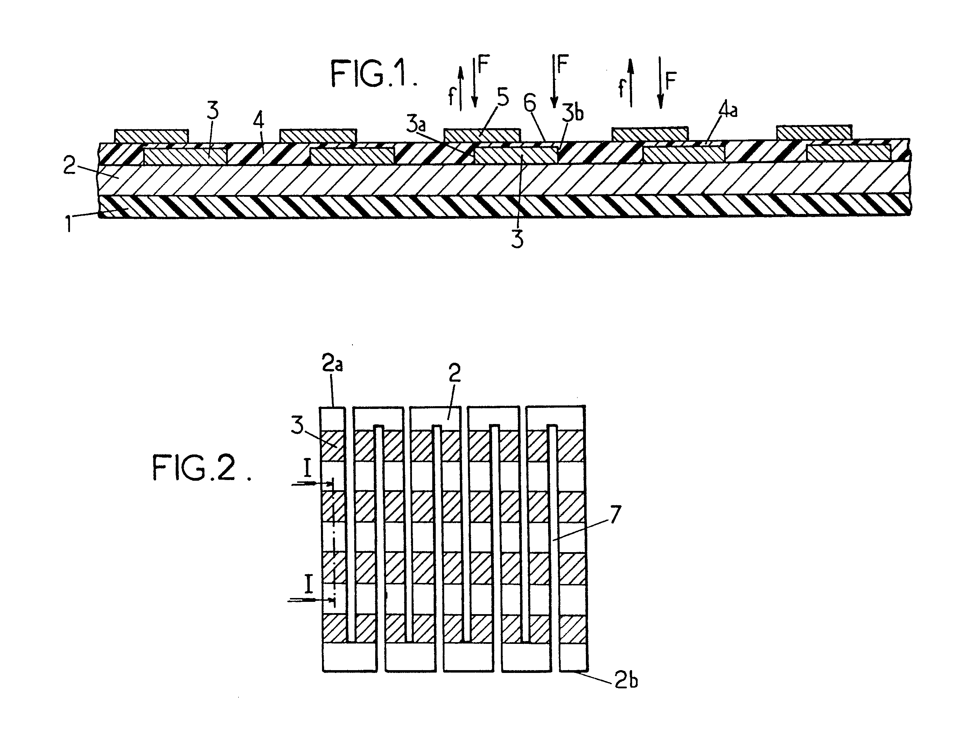

Les figures 1 et 2 sont des vues, respectivement en coupe par I-I de la figure 2, et schématiquement en plan, d'un dispositif pour la mesure d'un flux radiatif, de type connu, sensiblement conforme au brevet des Etats-Unis n° 3.267.727 précité.

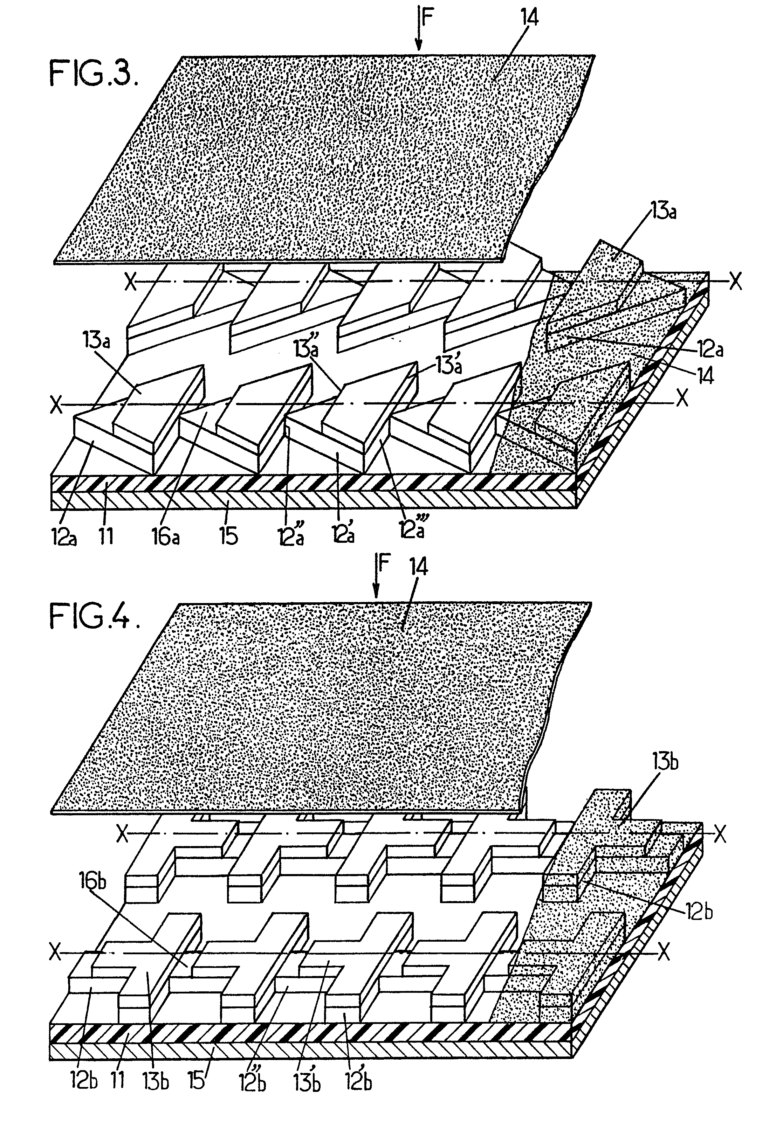

Les figures 3 et 4 illustrent, partiellement et en perspective cavalière, deux modes de réalisation d'un dispositif pour la mesure de l'intensité d'un flux radiatif mettant en oeuvre l'invention selon un premier type de modes de réalisation suivant lequel le revêtement fortement émissif (représenté en partie séparé du reste du dispositif) couvre à la fois l'ensemble des dépôts et la bande continue sous-jacente, les dépôts ayant la forme de trapèzes isocèles dans le cas de la figure 3 et de la lettre T dans le cas de la figure 4 et étant disposés sur une bande continue constituée par une succession ininterrompue de triangles isocèles (en fait équilatéraux) et de "T", respectivement sur les figures 3 et 4.

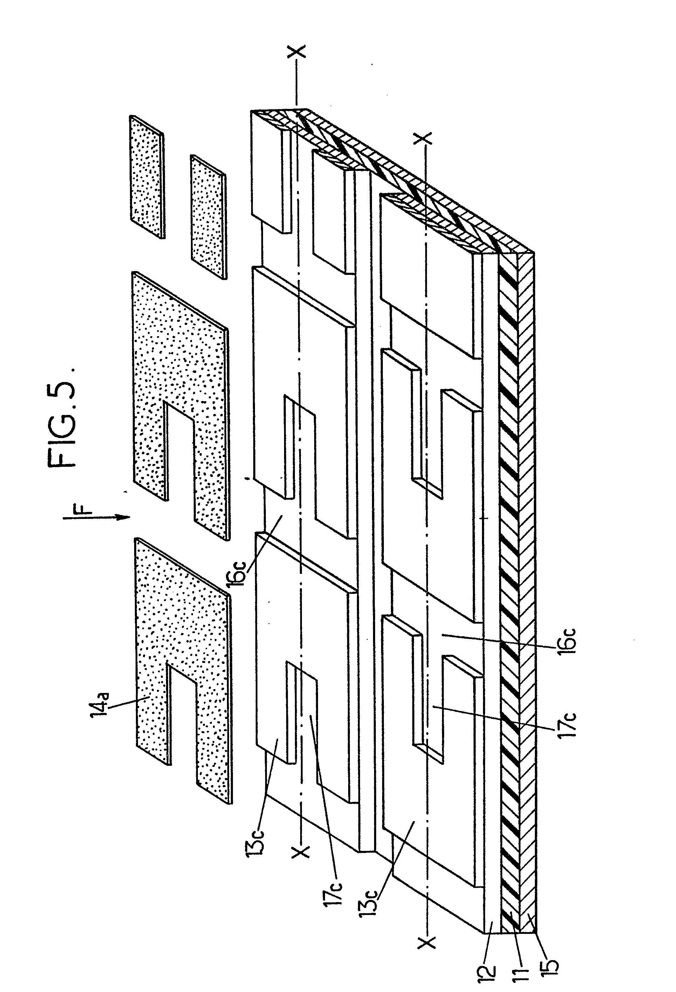

La figure 5 illustre, de manière analogue, un troisième mode de réalisation d'un dispositif de mesure de l'intensité d'un flux radiatif mettant en oeuvre l'invention selon un second type de modes de réalisation suivant lequel le revêtement fortement émissif (représenté séparé du reste du dispositif) couvre seulement les dépôts, qui ont dans ce troisième mode de réalisation, la forme de la lettre U, la bande continue ayant une largeur constante.

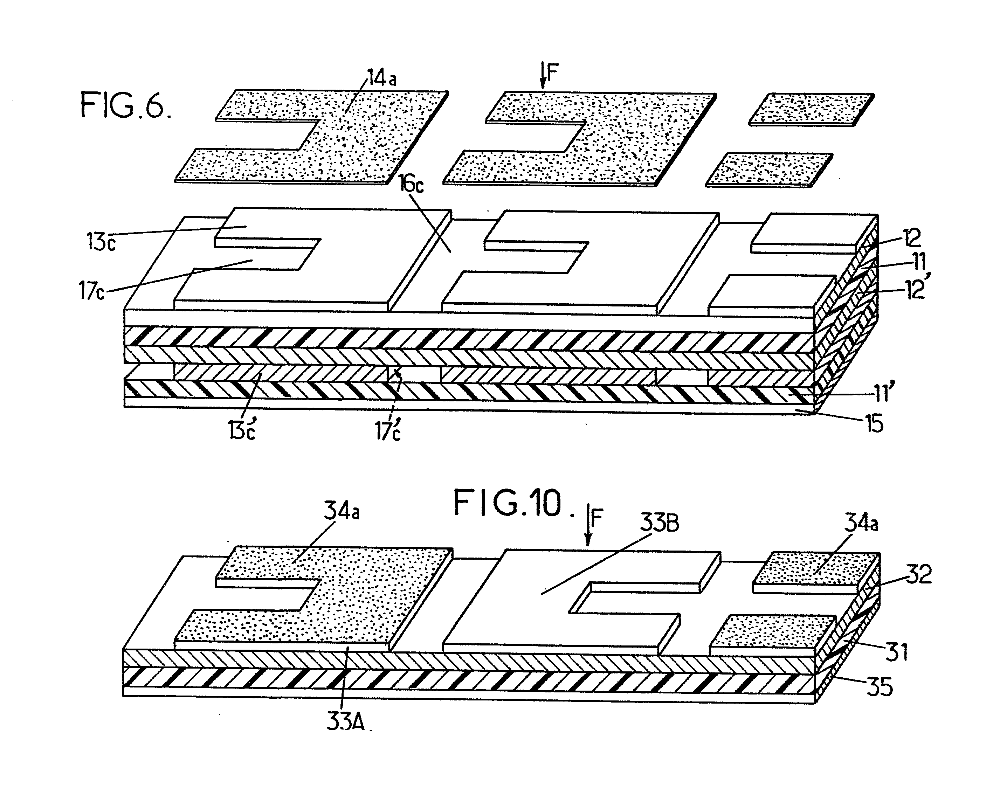

La figure 6 illustre, partiellement et en perspective cavalière, un quatrième mode de réalisation qui est une variante du mode de réalisation de la figure 5, à savoir un fluxmètre radiatif double face comportant, sur chaque face du support en matière isolante, une bande continue avec des dépôts et des revêtements fortement émissifs selon ce mode de réalisation de la figure 5.

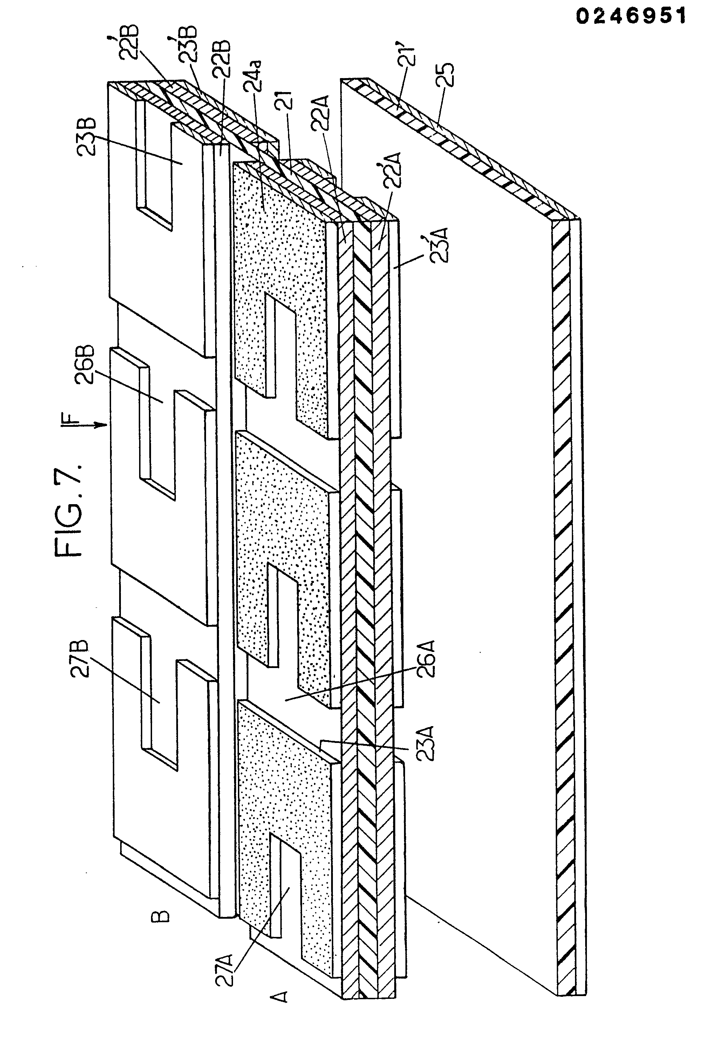

Les figures 7, 8 et 9 représentent un cinquième mode de réalisation qui dérive également du mode de réalisation de la fig.5, avec les deux modifications suivantes:
- d'une part, on a prévu un second fluxmètre de compensation dont la bande continue est imbriquée avec la bande continue du premier fluxmètre selon la figure 5, et,
- d'autre part, les deux fluxmètres sont à double face en étant disposés de part et d'autre du support en matière isolante,
la figure 7 (analogue à la figure 5) illustrant en perspective une partie médiane et la figure 8 illustrant en perspective une partie d'extrémité des deux fluxmètres double face, alors que la figure 9 est une vue en plan à plus petite échelle de l'ensemble des deux fluxmètres double face.
La figure 10 illustre partiellement et en perspective cavalière, un autre mode de réalisation à deux fluxmètres à bande continue unique comportant des dépôts successifs qui font partie alternativement du premier fluxmètre (dépôts recouverts d'un revêtement à forte émissivité) et du second fluxmètre (dépôts non recouverts d'un tel revêtement).
Les figures 11 et 12 illustrent, respectivement en perspective cavalière et en coupe par XII-XII de la figure 11, une partie d'un autre mode de réalisation de l'invention comportant des trous ou canaux traversant orthogonalement chaque dépôt et la portion de bande continue sous-jacente.
Les figures 13, 14 et 15 représentent des variantes des figures 5, 7 et 8, respectivement.
Avant d'exposer en détail comment on réalise selon l'invention un dispositif pour mesurer l'intensité d'un flux radiatif, on va décrire, avec référence aux figures 1 et 2, un dispositif pour cette mesure selon la technique antérieure sensiblement suivant l'enseignement du brevet des Etats-Unis précité n° 3.267.727.

Le dispositif des figures 1 et 2 comprend, sur un support isolant 1 carré ou rectangulaire, une bande conductrice méandriforme 2, par exemple en l'alliage appelé constantan, sur laquelle sont disposées des plaquettes rectangulaires conductrices 3, par exemple en cuivre. Une résine isolante à fort pouvoir émissif remplit les espaces 4 entre les plaquettes 3 au-dessus des zones de la bande continue 2 non recouvertes de plaquettes 3 et recouvre également les plaquettes 3 sous la forme d'une mince pellicule 4a.

Enfin le dispositif comporte des plaquettes 5 en une matière réfléchissante, c'est-à-dire à faible coefficient d'émissivité, par exemple en aluminium, qui se trouvent à cheval sur la moitié des jonctions bande 2-plaquette 3, à savoir sur une jonction sur deux de ce type.

La face supérieure (en considérant la figure 1) du dispositif présente donc une alternance de zones réfléchissantes 5 à faible pouvoir émissif et de zones 6 à fort pouvoir émissif, respectivement sur la première extrémité 3a et la seconde extrémité 3b de chaque plaquette 3.

Lorsque cette face supérieure reçoit un flux radiatif représenté par les flèches F, ce flux est réfléchi en quasi totalité par les plaquettes 5 (flèches f), mais est absorbé en quasi totalité par la résine dans les zones 6. De ce fait les jonctions bande 2-plaquette 3 aux extrémités 3a constituent des sources froides, tandis que les jonctions bande 2-plaquette 3 aux extrémités 3b deviennent des sources chaudes, la différence de température entre une source chaude et une source froide étant sensiblement proprotionnelle à l'intensité du flux radiatif F, si l'on ne tient pas compte des échanges thermiques radiatifs dont il a été fait mention ci-dessus.

Le dispositif des figures 1 et 2 convertit donc d'abord l'intensité d'un flux radiatif F en des différences de température entre les extrémités 3a et 3b, différences de température qui sont ensuite converties en f.e.m. par les couples thermoélectriques élémentaires comportant une plaquette 3 en cuivre et la portion de la bande continue 2 en constantan comprise entre une source froide 3a et une source chaude 3b.

Ces différents thermocouples élémentaires sont connectés en série par construction du fait que la bande 2 est une bande continue, en fait une bande méandriforme, comme on peut le voir sur la figure 2, les méandres successifs de la bande 2 étant séparés par des intervalles 7. La somme des forces électromotrices élémentaires engendrées par chaque thermocouple élémentaire, en réponse à l'intensité du flux radiatif F, est disponible entre les extrémités 2a et 2b de la bande 2 et il suffit de mesurer la force électromotrice totale résultante, disponible entre les extrémités 2a et 2b, avec un dispositif, de type connu, de mesure des f.e.m. pour avoir une mesure de l'intensité du flux radiatif F.

Toutefois, comme indiqué précédemment, cette mesure est peu sensible et en outre elle est entachée d'une erreur qui résulte des échanges thermiques radiatifs entre les sources chaudes 3b, d'une part, et les sources froides 3a, d'autre part, échanges qui ont tendance à réduire la différence de température entre les sources chaudes et les sources froides, ce qui entraîne une erreur sur la mesure de l'intensité du flux radiatif, la f.e.m. totale mesurée étant plus faible que celle qui correspondrait à l'intensité du flux radiatif F en l'absence de ces échanges radiatifs. En outre les thermocouples de ce brevet antérieur sont sensibles aux échanges par convection (dus par exemple à la ventilation) qui de façon générale provoquent des variations spatiales de température sur la surface du capteur.

La présente invention vise à pallier les inconvénients précités d'un dispositif, selon les figures 1 et 2, qui est essentiellement basé sur les différences d'émissivité des zones alternées 5 et 6 recouvrant des contacts alternés bande 2-plaquette 3, différences d'émissivité qui produisent des différences de température au niveau de ces contacts alternés en 3a et 3b.

Conformément à l'invention, on transforme directement en une f.e.m. (qui sera mesurée) le flux F, sans passer effectivement par une différence de température, et on compense dans les modes de réalisation préférés les erreurs introduites par les échanges thermiques convectifs sur la surface du fluxmètre.

Selon l'invention et plus spécialement selon celui de ses modes d'application, ainsi que selon ceux des modes de réalisation de ses diverses parties, auxquels il semble qu'il y ait lieu d'accorder la préférence, se proposant, par exemple, de réaliser un dispositif pour mesurer l'intensité d'un flux radiatif, on s'y prend comme suit ou d'une manière analogue.

Un premier type de mode de réalisation, à bande continue de largeur variable, d'un tel dispositif est illustré sur les figures 3 et 4 qui représentent, en perspective, seulement une partie du dispositif qui se présente en fait, comme illustré sur la figure 2, sous la forme d'une structure méandriforme, les figures 3 et 4 illustrant une portion de deux méandres successifs du dispositif méandriforme.

Dans les deux modes de réalisation des figures 3 et 4, on prévoit un support mince 11 en une matière isolante, par exemple en la matière plastique appelée "kapton", ce support étant rectangulaire ou éventuellement carré. Sur ce support est disposée une bande continue mince 12 méandriforme (du type de la bande 2 de la figure 2), cette bande 12 étant réalisée en une première matière conductrice, par exemple en l'alliage appelé "constantan" et ayant une forme telle que la largeur (dans la direction transversale par rapport à l'axe XX d'allongement d'un méandre) varie suivant la direction de l'axe XX.

Sur cette bande continue 12a ou 12b sont disposés l'un derrière l'autre une série de dépôts discontinus, en une seconde matière conductrice, qui sont réalisés de préférence par voie électrolytique et par exemple en cuivre, étant plus minces que la bande 12.

Dans le mode de réalisation de la figure 3 la bande continue 12a est constituée par une succession ininterrompue de triangles isocèles ou même équilatéraux (comme illustré) 12'a qui se touchent les uns les autres pour assurer la continuité électrique de cette bande 12a, tandis que les dépôts 13a ont la forme de trapèzes isocèles dont la base la plus large 13'a coïncide avec la base 12"'a du triangle 12'a qui le supporte et dont la base la plus étroite 13"a est du côté du sommet ou pointe 12"a du triangle 12'a correspondant. La symétrie des triangles 12'a et des trapèzes 13a est relative à l'axe XX.

Sur la figure 4 la bande continue 12b est constituée par une succession ininterrompue d'unités en forme de la lettre T 12'b qui se touchent pour assurer la continuité électrique de cette bande 12b et les dépôts 13b ont aussi la forme de la lettre T mais avec une barre longitudinale 13'b plus courte que la barre longitudinale 12"b des "T" de la bande continue de manière que les dépôts soient séparés les uns des autres. Les "T" 12'b et 13b des deux séries sont disposés symétriquement par rapport à l'axe XX.

On notera que l'orientation commune des variations de largeur de la bande continue et des dépôts discontinus sur un même méandre est la même, les sommets 12"a des triangles et les petites bases 13"a des dépôts (figure 3) et les barres longitudinales 12"b et 13'b des "T" (figure 4) étant dirigés dans le même sens, alors que sur deux méandres successifs les orientations communes de la variation de largeur de la bande et des dépôts sont opposées.

Le dispositif des figures 3 et 4 comporte également un revêtement 14 en une matière à fort pouvoir émissif, qui est représenté sur ces figures en grande partie à distance des dépôts 13a et 13b afin de faciliter la lisibilité de ces figures; ce revêtement 14 est appliqué étroitement contre ces dépôts et la bande continue 12a et 12b comme illustré sur la partie droite des figures 3 et 4. Ce revêtement, qui a sensiblement le pouvoir émissif du corps noir, est par exemple en une peinture mate noire utilisée pour fabriquer les corps noirs et appelée dans la technique "gold black".

Des moyens (non représentés) sont connectés aux deux extrémités de la bande conductrice méandriforme 12 (correspondant aux extrémités 2a et 2b de la figure 2 qui illustre une telle forme méandriforme) afin de mesurer la force électromotrice totale produite entre ces deux extrémités lorsqu'un flux radiatif F d'intensité I est dirigé sensiblement perpendiculairement au revêtement 14 du dispositif selon l'invention illustré partiellement sur les figures 3 et 4.

Enfin on peut prévoir une couche mince 15, en une matière bonne conductrice de la chaleur, telle que le cuivre, sous le support 11 (en regardant les figures 3 et 4), notamment lorsque le dispositif selon l'invention est destiné à être appliqué contre une surface ou paroi, la couche 15 assurant une uniformisation à l'échelle des thermocouples élémentaires de la température moyenne de la surface ou paroi dont on veut mesurer, grâce au dispositif illustré en partie sur les figures 3 ou 4, le flux radiatif F qu'elle reçoit ou le flux radiatif net Fn qu'elle échange avec l'ambiance ou une autre surface ou paroi qui se trouve à une température différente.

On notera que l'ensemble du dispositif: support 11 avec bande continue méandriforme 12, dépôts 13a ou 13b, revêtement 14 et couche 15 éventuelle peut être constitué avantageusement en tant que circuit imprimé souple.

Les épaisseurs des différentes couches peuvent être les suivantes :

support 11 : 50 μm

bande continue méandriforme 12 : 25 μm

dépôts 13a ou 13b : 6 μm

revêtement 14 à forte émissivité : 2 μm

couche 15 conductrice de la chaleur : 30 μm

Le fonctionnement des dispositifs selon les figures 3 et 4 est le suivant.

Le flux radiatif est absorbé de façon uniforme par le dépôt de forte émissivité et est une source thermique localisée sur la surface du fluxmètre. Les flux thermiques circulant suivant les chemins de plus faible résistance thermique et le support 11 en matière isolante ayant une conductivité beaucoup plus faible que celle de la bande 12a, 12b en constantan et des dépôts discontinus 13a, 13b en cuivre, il y a circulation de flux thermique tangentiel dans la bande continue 12.

L'amplitude du flux thermique, selon la direction XX, dans la bande continue 12a, 12b est fonction de la largeur de cette bande continue et/ou des dépôts discontinus, cette amplitude diminuant lorsque cette largeur diminue, et ceci d'autant plus que le support 11 est mince, d'où intérêt à prévoir un support 11 très mince.

Du fait que la bande continue 12a, 12b et/ou les dépôts discontinus présentent une largeur variable (dans la direction transversale par rapport à la direction XX), les flux thermiques dans la direction XX, qui convergent vers les régions 16a ou 16b de la bande 12a, 12b non revêtues de dépôts 13a ou 13b, sont d'amplitude inégale et provoquent des forces électromotrices dans ces régions 16a ou 16b.

Les dépôts électrolytiques discontinus situés sur la bande continue 12a, 12b (les dépôts 13a ou 13b), au niveau des différentes régions 16a ou 16b, provoquent une division du flux radiatif absorbé net entre une composante normale et une composante tangentielle à la surface du fluxmètre circulant entre les dépôts 13a ou 13b et les régions 16a ou 16b de la bande 12a, 12b non recouvertes de dépôts cuivrés.

Il y a donc conversion directe des variations spatiales du flux radiatif net au niveau de chaque thermocouple élémentaire, constitué par un dépôt 13a ou 13b en cuivre et la portion adjacente de la bande 12a, 12b en constantan, les f.e.m. élémentaires s'ajoutant du fait de l'orientation des dépôts 13a et 13b qui, si l'on parcourt toute la longueur méandriforme de la bande 12a, 12b sont dirigées toujours dans le même sens.

La f.e.m. totale est facilement détectable par les moyens de mesure précités et non représentés.

On obtient ainsi une grande sensibilité qui peut être de l'ordre de 0,4 mV par watt radiatif et par décimètre carré de dispositif selon l'invention et une faible constante de temps de l'ordre de une seconde.

Un deuxième type de mode de réalisation est illustré sur la figure 5 sur laquelle on retrouve le support 11, avantageusement en kapton, la bande continue méandriforme, avantageusement en constantan, et les dépôts discontinus avantageusement en cuivre; la bande continue, référencée 12, a une largeur constante dans le mode de réalisation de la figure 5, tandis que les dépôts, référencés 13c, ont, dans ce mode de réalisation, la forme d'un U, mais bien entendu ils pourraient également avoir la configuration illustrée sur la figure 3 ou la figure 4.

On notera que les ouvertures 17c des U sur un même méandre sont dirigées dans un même sens, tandis que sur deux méandres successifs les sens des ouvertures 17c sont opposés.

Le dispositif de la figure 5 peut également être revêtu à sa partie inférieure, comme dans le cas des figures 3 et 4, d'une mince couche 15 conductrice de la chaleur, avantageusement en cuivre.

La différence essentielle entre les modes de réalisation des figures 3 et 4, suivant le premier type, et le mode de réalisation de la figure 5, suivant le deuxième type, est constituée par le fait qu'au lieu d'avoir (comme sur les figures 3 et 4) un revêtement continu 14 fortement émissif qui recouvre la totalité de la face supérieure du dispositif, on prévoit, dans le mode de réalisation de la figure 5, des revêtements discrets 14a qui ont la même forme que les dépôts 13c et qui recouvrent uniquement ces dépôts 13c (sur la figure 5 on a écarté les revêtements 14a des dépôts 13c uniquement pour faciliter la lecture de cette figure).

Dans le cas du dispositif selon la figure 5, on peut avantageusement recouvrir les régions 16c de la bande 12, non couvertes par des dépôts 13c, au moyen d'une peinture ou d'un revêtement d'émissivité très faible, par exemple d'une peinture à l'aluminium ou d'un revêtement en aluminium ayant une émissivité de l'ordre de 0,1, alors que le revêtement 14a présente une émissivité de l'ordre de 1, comme le revêtement 14. L'épaisseur des revêtements d'émissivité faible peut être de l'ordre de 1 μm.

Le même phénomène de division du flux radiatif net entre dépôts cuivrés 13c, d'une part, et régions 16c non cuivrées (y compris ouvertures 17c), d'autre part, que dans les modes de rélisation des figures 3 et 4 se produit dans le mode de réalisation de la figure 5. Il y a donc également dans ce dernier mode de rélisation une conversion directe des variations spatiales du flux radiatif net en des f.e.m. élémentaires pour chaque dépôt 13c, la somme des f.e.m. en série étant facilement détectable.

Un mode de réalisation particulièrement avantageux du dispositif selon la figure 5 consiste à prévoir une oxydation superficielle des dépôts de cuivre 13c à haute température dans une atmosphère oxydante, ce qui aboutit à la transformation en surface du cuivre des dépôts en oxyde de cuivre noir, les pellicules d'oxyde de cuivre noir s-

0246951

20

perficiel constituant les revêtements 14a à forte émissivité (de l'ordre de 1).

Pour accroître la sensibilité d'un dispositif selon l'invention on peut réaliser un fluxmètre radiatif double face en disposant, non pas d'un seul côté du support 11 une bande continue 12a, 12b ou 12 recouverte en partie de dépôts 13a, 13b ou 13c couverts à leur tour d'un revêtement continu 14 ou de revêtements discrets 14a, mais des deux côtés du support 11, une bande continue recouverte partiellement de dépôts.

Un mode de réalisation d'un fluxmètre radiatif double face selon l'invention est illustré sur la figure 6 qui ne représente partiellement qu'un seul méandre.

Sur la figure 6 on retrouve le support 11, la bande 12, les dépôts 13c et les revêtements discrets 14a ainsi que les zones 16c, du mode de réalisation de la figure 5; en outre sous le support 11 (en considérant la figure 6), on a prévu une seconde bande continue 12' analogue à la bande 12, c'est-à-dire méandriforme, cette bande continue méandriforme 12' étant recouverte partiellement de dépôts 13'c analogues aux dépôts 13c, ces dépôts 13'c étant recouverts ou non de revêtements à forte émissivité (sur la figure 6 on a illustré la variante sans revêtements à forte émissivité sur les dépôts 13'c).

On notera que les ouvertures 17c des dépôts 13c sur un méandre de la face supérieure sont toutes orientées dans le même sens, alors que les ouvertures 17'c des dépôts 13'c du méandre correspondant de la face inférieure sont orientées dans le sens opposé à celui-ci.

Enfin l'ensemble décrit ci-dessus est placé sur un support supplémentaire 11', analogue au support 11, qui peut être recouvert sur sa partie inférieure par une couche 15 en une matière bonne conductrice de la chaleur, telle que le cuivre, notamment lorsque le dispositif selon la figure 6 est destiné à être appliqué contre une surface ou paroi dont on veut étudier les échanges thermiques avec l'ambiance ou avec une autre surface ou paroi à une température différente.

Grâce à ce montage double face du fluxmètre radiatif de la figure 6 on arrive à presque doubler la sensibilité par décimètre carré de surface et par watt radiatif en atteignant ou en se rapprochant d'une sensibilité de l'ordre de 1 mV par watt radiatif et par décimètre carré de surface de dispositif double face.

Dans les quatre modes de réalisation précédents (ceux des figures 3 à 6), il existe des échanges thermiques par convection, entre les dépôts cuivrés 13a, 13b ou 13c, dans les volumes d'air dans les espaces (entre dépôts cuivrés) surmontant les régions 16a, 16b ou 16c non recouvertes de dépôts. Ces échanges radiatifs par convection provoquent l'apparition d'une f.e.m. de convection qui généralement se retranche de la f.e.m. due au flux radiatif et qui fausse donc la mesure de ce flux.

Ces modes de réalisation sont également sensibles aux échanges convectifs externes présents sur la surface du fluxmètre.

Une disposition particulièrement avantageuse pour mesurer avec précision uniquement le flux radiatif, en éliminant la f.e.m. due aux échanges par convection, consiste à mettre en oeuvre un montage différentiel permettant d'éliminer par compensation les f.e.m. dues aux échanges convectifs.

De préférence on utilise à cet effet deux fluxmètres radiatifs selon l'invention à revêtements d'émissivités différentes, étroitement associés pour être soumis aux mêmes échanges radiatifs extérieurs, ces fluxmètres absorbant des flux radiatifs différents compte-tenu des émissivités différentes des revêtements utilisés.

Le second fluxmètre, dit de compensation, présente la même structure (exposée ci-dessus) que le fluxmètre principal et il comporte donc également une bande continue, avantageusement méandriforme, en une première matière conductrice, telle que le constantan, avec des dépôts discontinus, avec une dissymétrie, en ce qui concerne la largeur, des dépôts et éventuellement de la bande, dans la direction transversale par rapport à la direction de la bande continue méandriforme, les dépôts du second fluxmètre n'étant pas recouverts d'un revêtement à forte émissivité.

Pour réaliser une compensation correcte, on donne la même forme géométrique et les mêmes dimensions aux dépôts des deux fluxmètres selon l'invention, ainsi qu'aux bandes continues de ces deux fluxmètres.

De ce fait, si l'on mesure la différence entre la somme des f.e.m. élémentaires du fluxmètre principal avec des revêtements fortement émissifs au moins sur les dépôts discontinus et la somme des f.e.m. élémentaires du fluxmètre de compensation sans de tels revêtements, on élimine l'influence des échanges thermiques convectifs du fait que ces échanges provoquent la même somme de f.e.m. élémentaires dans les deux fluxmètres.

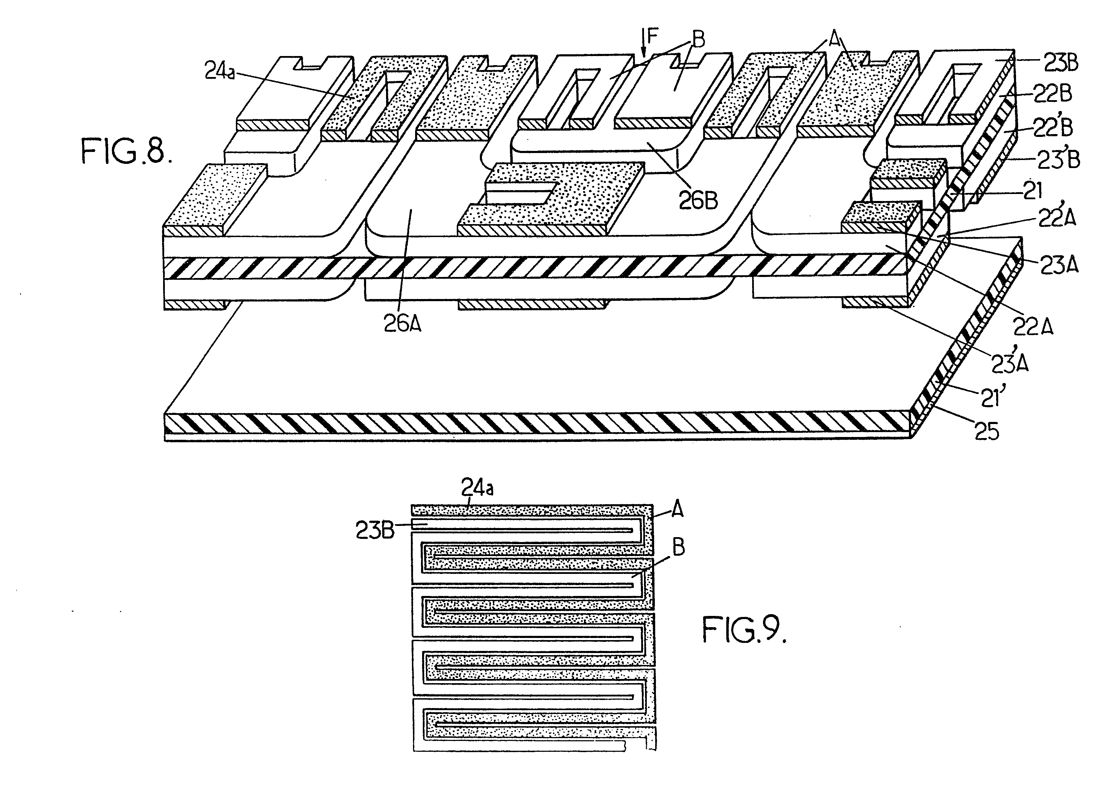

Un premier mode de réalisation d'un ensemble combiné de deux fluxmètres radiatifs double face, selon l'invention, est illustré sur les figures 7, 8, 9. En particulier sur la figure 7 on a illustré côte à côte un méandre combiné comportant une portion A de fluxmètre principal et une autre portion B de fluxmètre de compensation, les deux à double face. La figure 8 illustre le même fluxmètre combiné à double face en perspective mais vu en bout.

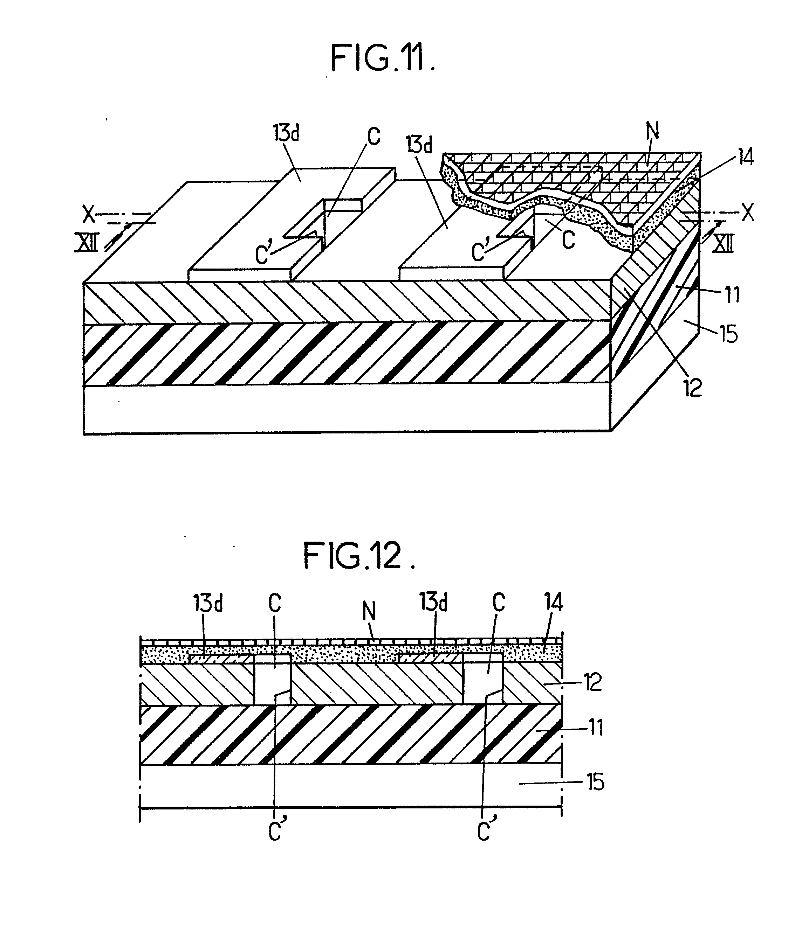

L'ensemble des deux fluxmètres comporte un support isolant 21, par exemple en kapton, sur lequel sont disposées deux bandes conductrices continues 22A et 22B, par exemple en constantan, ces deux bandes étant méandriformes et indépendantes l'une de l'autre, mais disposées avec leurs méandres côte à côte, comme illustré sur la figure 9 qui représente en plan l'ensemble du fluxmètre combiné. Les deux bandes 22A et 22B sont recouvertes respectivement de dépôts conducteurs 23A et 23B, par exemple en cuivre, les surfaces libres des dépôts 23A étant noircies, par exemple par oxydation du cuivre, pour former des revêtements 24a à forte émissivité, alors que les surfaces libres des dépôts 23B ne sont pas noircies et présentent donc l'éclat métallique.

Les deux fluxmètres (principal A et de compensation B) étant identiques à part le noircissement des dépôts 23A et étant soumis au même flux radiatif F subissent les mêmes échanges thermiques par convection au-dessus des portions 26A et 26B non recouvertes de dépôts cuivrés, les f.e.m. totales produites dans les fluxmètres A et B par ces échanges radiatifs se compensant exactement du fait de la similitude des formes et de l'orientation contraire des ouvertures 27A et 27B des dépôts 23A et 23B respectivement, par exemple en U comme on le voit sur la figure 7.

De ce fait, si l'on mesure la somme algébrique des f.e.m. élémentaires aux deux extrémités du double fluxmètre A-B, on obtient une f.e.m. globale qui est uniquement fonction du flux radiatif en étant strictement proportionnelle à celui-ci

On réalise donc ainsi un dispositif intégré qui mesure avec une excellente précision un flux radiatif.

Le dispositif des figures 7 à 9 peut être du type double face comme illustré, en prévoyant deux bandes continues de constantan sous le support de kapton 21, ces bandes étant revêtues à leur tour de dépôts de cuivre discontinus et de largeur variable.

Ainsi sur les figures 7 et 8 on a illustré deux telles bandes continues 22'A et 22'B en constantan et des dépôts 23'A et 23'B de cuivre, seuls les dépôts 23'A pouvant être recouverts à leur tour de revêtements fortement émissifs (non représentés).

On notera enfin que, sous les dépôts de cuivre 23'A (couverts de revêtements fortement émissifs) et 23'B, on dispose un support isolant supplémentaire 21', par exemple en kapton, et une couche conductrice 25, par exemple en cuivre, cette couche venant contre la surface ou la paroi dont on veut étudier les échanges thermiques avec l'ambiance ou avec une autre surface ou paroi qui se trouve à une température différente.

La disposition géométrique de ces fluxmètres radiatifs combinés, principal et de compensation, chacun à double face, dont une portion de méandre a été illustrée en perspective cavalière sur la figure 7 sera mieux comprise en se référant aux figures 8 et 9, la figure 9, qui représente l'ensemble des fluxmètres combinés, double face, vu par dessus, montrant la disposition emboîtée des bandes continues des deux fluxmètres, à savoir la bande 22A dont les dépôts 23A sont recouverts de revetêments 24a à forte émissivité (sur la figure 9 on a, vu l'échelle, représenté ces revêtements 24a comme s'ils étaient continus, alors qu'en fait ils sont discrets comme illustré sur les figures 7 et 8) et la bande 22B dont les dépôts 23B ne sont pas recouverts de revêtement à forte émissivité.

La figure 8 est une vue en perspective comme la figure 7 montrant partiellement une des extrémités du dispositif, par exemple l'extrémité de gauche de la figure 9 et illustrant la disposition imbriquée des deux fluxmètres.

Dans le mode de réalisation des figures 7 à 9, les deux fluxmètres radiatifs sont sensiblement indépendants tout en étant disposés de part et d'autre d'un support commun 21, l'ensemble des fluxmètres étant disposé sur un support isolant supplémentaire 21' éventuellement recouvert d'une couche 25 conductrice de la chaleur, et ils comportent chacun une bande continue sur chacune des faces du support 21, les deux fluxmètres étant imbriqués ou enchevêtrés, comme on peut le voir en particulier sur les figures 8 et 9.

Un autre mode de réalisation d'un ensemble de deux fluxmètres, principal et de compensation, est illustré sur la figure 10 sur laquelle on a représenté en perspective une partie d'un seul méandre de ces fluxmètres disposés sur une seule face d'un support 31, par exemple en kapton.

Dans le mode de réalisation de la figure 10, on prévoit une seule bande continue 32 méandriforme commune aux deux fluxmètres et qui est revêtue d'une succession de dépôts discontinus alternés 33A, 33B qui ont la même forme en U que les dépôts 13c de la figure 5 et 23A et 23B des figures 7 et 8. Toutefois ces dépôts discontinus en U sont disposés alternativement avec leurs ouvertures dans un sens (dépôts 33A) et dans l'autre (dépôts 33B).

Seuls les dépôts 33A dont l'ouverture est dirigée dans un premier sens sont recouverts d'un revêtement 34a à forte émissivité, les dépôts 33B dont l'ouverture est dirigée dans l'autre sens n'étant pas recouverts de revêtement à forte émissivité.

Dans ces conditions la bande continue 32 et les dépôts 33A avec les revêtements fortement émissifs 34a constituent le fluxmètre principal, alors que la même bande continue 32 avec les dépôts 33B non recouverts de revêtement à forte émissivité constituent un fluxmètre de compensation essentiellement sensible aux échanges convectifs.

Du fait de l'orientation inverse des dépôts 33A et des dépôts 33B, les f.e.m. engendrées dans les deux fluxmètre radiatifs, par suite des échanges thermiques convectifs, se compensent exactement dans la f.e.m. globale disponible aux extrémités de la bande continue méandriforme 32 commune aux deux fluxmètres, cette f.e.m. globale étant une mesure exacte de l'intensité du flux radiatif F qui frappe la face supérieure du fluxmètre dont on a illustré une portion sur la figure 10.

On voit, en définitive, que, dans les modes de réalisation des figures 3 à 10, un fluxmètre radiatif selon l'invention comporte : une bande continue, avantageusement méandriforme, réalisée en une première matière conductrice, telle que l'alliage constantan; une succession de dépôts discontinus en une seconde matière conductrice ayant un pouvoir thermoélectrique différent de celui de la première matière et une plus grande conductivité, cette seconde matière étant avantageusement du cuivre, les dépôts discontinus et éventuellement la bande continue ayant une largeur (dans la direction transversale) qui varie lorsqu'on la considère dans le sens longitudinal XX; un revêtement à fort pouvoir émissif qui recouvre au moins l'ensemble des dépôts discontinus, ce revêtement pouvant également recouvrir les régions de la bande continue sur lesquelles il n'y a pas de dépôts; et des moyens pour mesurer la f.e.m. disponible aux extrémités de la bande. Avantageusement le fluxmètre se présente sous la forme d'un circuit imprimé souple.

On a indiqué plusieurs formes possibles des dépôts (en triangle isocèle; en T, en U), chacune de ces formes ou des formes différentes pouvant être utilisée dans les différents modes de réalisation, à savoir tant dans le cas d'un revêtement à fort pouvoir émissif uniquement sur les dépôts, avec éventuellement le dépôt d'une couche à faible pouvoir émissif sur les régions de la bande continue non recouvertes de dépôts, que dans le cas d'un revêtement à fort pouvoir émissif recouvrant l'ensemble des dépôts et des régions non recouverts de dépôts.

Enfin sur les figures 11 et 12 on a illustré un mode de réalisation d'un fluxmètre radiatif selon l'invention, du type simple face et sans fluxmètre radiatif de compensation, dans lequel la dissymétrie de la chaîne de thermocouples en série est réalisée au moyen de trous ou évidements qui découpent transversalement la bande continue et les dépôts discontinus.

Bien entendu un tel fluxmètre pourrait être combiné à un fluxmètre de compensation, comme expliqué ci-dessus, et/ou être du type double face, comme exposé ci-dessus pour des fluxmètres radiatifs sans trous ou évidements.

Dans le mode de réalisation des figures 11 et 12 on retrouve de bas en haut la couche conductrice 15, le support isolant 11, la bande continue 12, par exemple en constantan, et avantageusement méandriforme, des dépôts discontinus référencés 13d, par exemple en cuivre, et un revêtement fortement émissif 14 du type continu comme sur les figures 3 et 4 et recouvrant la surface supérieure des dépôts 13d et de la bande continue 12 aux endroits non revêtus de ces dépôts.

La largeur à la fois de la bande continue 12 et des dépôts discontinus 13d est constante dans ce mode de réalisation, contrairement à ce qui était le cas dans les autres modes de réalisation précédemment décrits.

La dissymétrie est réalisée dans le fluxmètre des figures 11 et 12 au moyen de trous ou évidements C qui découpent orthogonalement les dépôts 13d et la bande continue 12. Il est essentiel que ces trous ou évidements C soient décalés dans la direction longitudinale et toujours dans le même sens par rapport au centre des dépôts discontinus 13d. Par direction longitudinale on entend ici, comme dans les autres modes de réalisation, le sens d'allongement de la bande continue, que celle-ci soit rectiligne ou méandriforme comme préféré, ou éventuellement enroulée en spirale. Les trous ou évidements C peuvent être soit disposés jusqu'à une extrémité des dépôts 13d (comme dans le mode de réalisation des figures 11 et 12), soit à une certaine distance de la même extrémité dans le sens d'allongement de la bande continue.

Les trous ou évidements C peuvent être revêtus intérieurement en C' d'une matière conductrice, avantageusement la même que celle des dépôts 13d.

Enfin on peut prévoir une structure "en nid d'abeilles" N au-dessus du revêtement émissif 14, cette structure ayant pour effet de limiter les effets convectifs dans le plan horizontal au-dessus du revêtement 14

(en regardant les figures 11 et 12).

Il y a lieu de noter qu'une telle structure en nid d'abeilles peut être avantageusement disposée également sur les modes de réalisation des figures 3 à 10.

En ce qui concerne le fonctionnement du fluxmètre radiatif selon les figures 11 et 12, ce sont les trous ou évidements C qui réalisent une dissymétrie thermique, car le flux thermique évite ces trous préférentiellement, étant donné que l'air est très mauvais conducteur, alors que les première et seconde matières conductrices de la bande continue 12 et des dépôts 13d sont beaucoup plus conductrices de la chaleur que l'air. Etant entendu que le revêtement émissif 14 joue le même rôle dans ce mode de réalisation que dans les modes de réalisation précédents, il se crée alors une différence de température dans le plan horizontal entre les extrémités de gauche et de droite (en considérant les figures 11 et 12) de chaque dépôt 13d, ce qui engendre une force électromotrice d'origine thermoélectrique aux extrémités de chaque thermocouple élémentaire; or ces thermocouples sont connectés en série par la bande 12 et on obtient finalement une différence de potentiel notable entre les extrémités de la bande grâce à la mise en série d'un très grand nombre de thermocouples élémentaires.

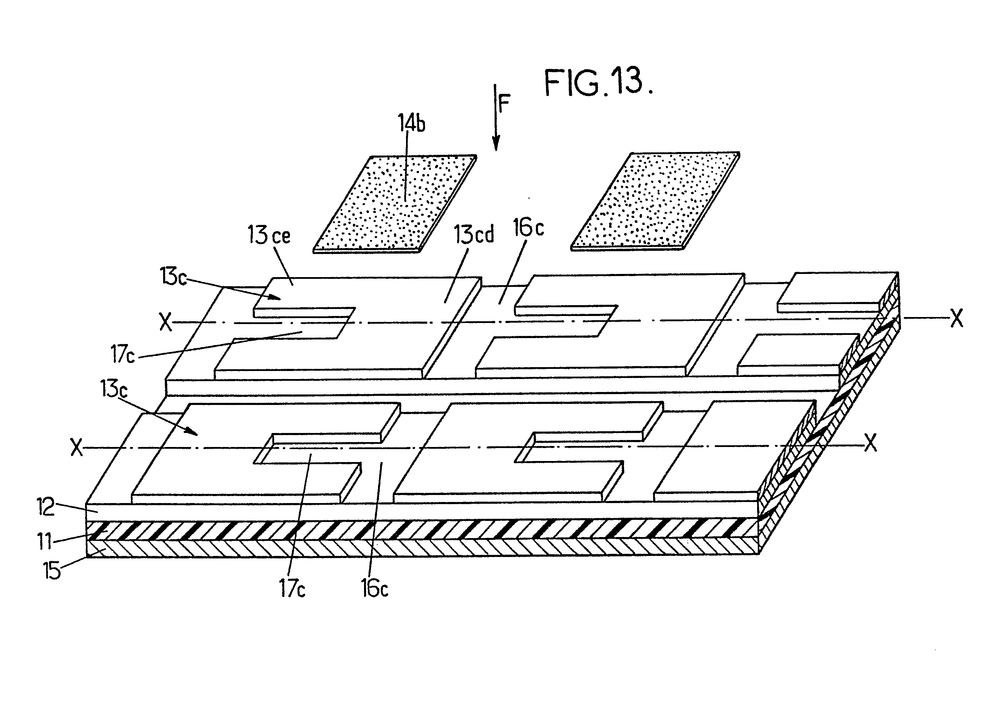

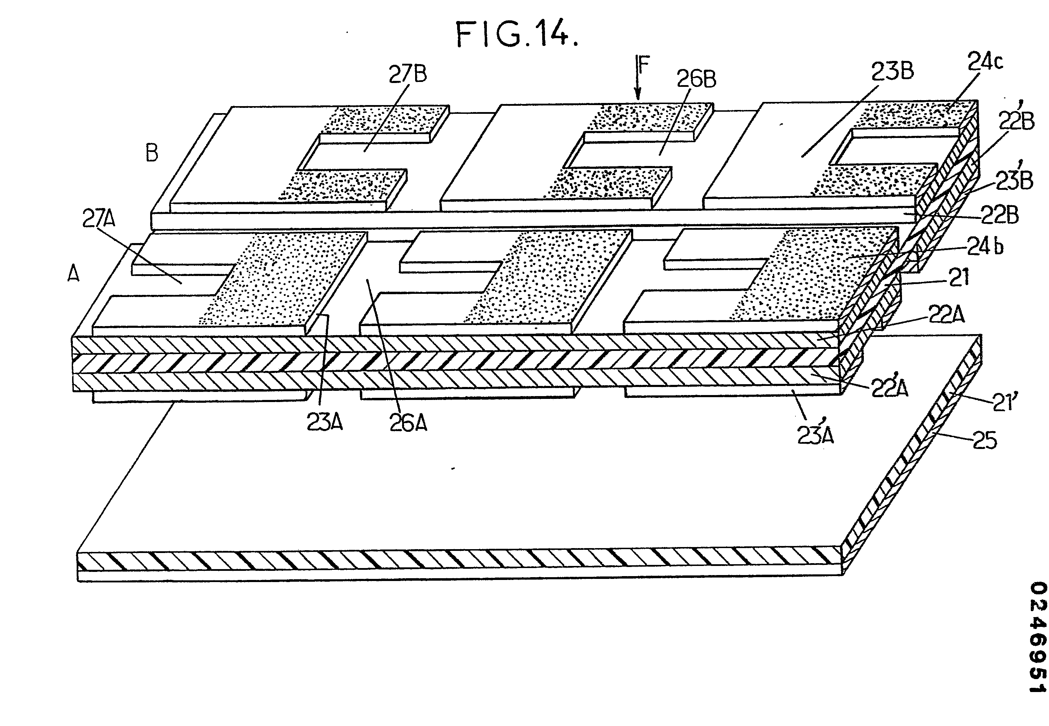

Sur la figure 13, on a illustré une variante du mode de réalisation de la figure 5, la seule différence entre les dispositifs des figures 13 et 5 étant constituée par la forme des revêtements à forte émissivité référencés 14a sur la figure 5 et 14b sur la figure 13.

Dans le mode de réalisation de la figure 5, les revêtements 14a ont la forme de la lettre U et recouvrent entièrement les dépôts 13c, tandis que, dans la variante de la figure 13, les revêtements 14b sont rectangulaires et ne recouvrent que les parties 13cd non entaillées des dépôts 13c en U et non pas les ailes 13ce de ces dépôts.

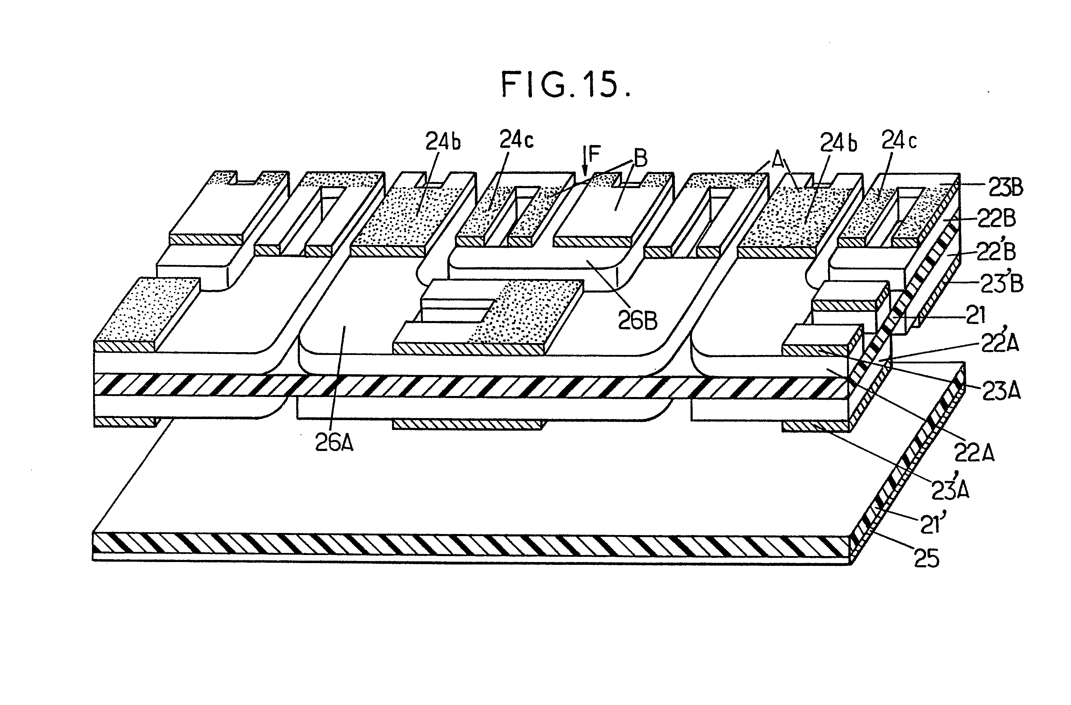

De même, sur les figures 14 et 15, on a illustré une variante de l'ensemble des figures 8 et 9, variante dans laquelle les revêtements à forte émissivité, sur les dépôts 23A (et 23'A) du fluxmètre principal A, revêtements référencés 24b, ont également une forme rectangulaire (et non pas la forme en U des dépôts 24a de la figure 7) ; par contre, des revêtements à forte emissivité sont également prévus sur le fluxmètre de compensation B, à savoir sur les pattes des dépôts 23B (et 23'B), ces derniers revêtements étant référencés 24c.

Dans le cas d'une utilisation à de hautes températures, pouvant atteindre et dépasser 600°C, et même jusqu'à 1500°C, on peut constituer, dans un dispositif selon l'invention, le support mince 11, 21, 31 en matière isolante, non pas en kapton, matière qui ne résiste pas à des températures élevées, mais en une céramique telle que le produit vendu par la "Société des Procédés Industriels KAGER" à Steinseltz, France, sous la dénomination "TYPE 963" et qui est un système monocomposant à base d'alumine $Al_2O_3$. Il s'agit en fait d'une pâte qui adhère à la surface sur laquelle elle est appliquée et qui devient de la céramique réfractaire après cuisson. On peut également disposer d'abord une couche de kapton pour réaliser l'assemblage mécanique puis dissoudre cette couche de kapton dans de la soude, la pâte céramique assurant la liaison entre les parties accolées, par exemple les couches 12 et 15.

Par ailleurs, dans le cas des modes de réalisation des figures 7-8 et 14-15, les évidements entre les branches de l'U des dépôts discontinus 23A et 23B de la face supérieure et 23'A et 23'B de la face inférieure peuvent être d'une longueur (dans le sens d'allongement de la bande continue 26A) telle qu'une partie de la portion interne de ces évidements de la face supérieure vienne chevaucher une partie de la portion interne des évidements correspondants de la face inférieure.

Un dispositif selon l'invention, dans le cas où il comporte à la fois un fluxmètre principal A et un fluxmètre de compensation B, permet de mesurer séparément l'intensité d'un flux radiatif et l'intensité d'un flux convectif. En effet, ces deux fluxmètres A et B déterminent chacun une quantité (en particulier une force électromotrice) qui est une fonction linéaire de chacun de ces deux flux. Ainsi, si l'on désigne par X et Y respectivement le flux radiatif et le flux convectif, que perçoit l'ensemble des deux fluxmètres A et B, et par m, n, m' et n' quatre constantes, on aura, aux sorties des deux fluxmètres A et B, les valeurs (en particulier les forces électromotrices) respectives G(A) et G(B) telles que :

$$\begin{cases} G(A) = mX + nY \\ G(B) = m'X + n'Y. \end{cases}$$

Ces deux équations à deux inconnues X et Y sont résolvables en X et Y et, à cet effet, on peut utiliser un amplificateur opérationnel ou un micro-ordinateur qui reçoit, sur ses deux entrées, G(A) et G(B) (sorties des fluxmètres A et B, respectivement) et qui débitera, sur ses deux sorties, X et Y, les constantes m, n, m' et n' étant déterminées.

On constatera que le dispositif ou fluxmètre radiatif selon l'invention se distingue d'un fluxmètre radiatif de la technique antérieure selon le brevet Etats-Unis n° 3.267.727 précité du fait de la variation de largeur des dépôts discontinus et éventuellement de la bande continue sous-jacente, dans la direction longitudinale de la bande et du fait d'un revêtement fortement émissif recouvrant en totalité au moins les dépôts.

Le dispositif ou fluxmètre radiatif selon l'invention se distingue par ailleurs des fluxmètres purement thermiques selon le brevet européen n° 0 030 499 et le brevet français n° 2.536.536, tous deux au nom de l'Agence Nationale de Valorisation de la Recherche (ANVAR), par le fait qu'il comporte un revêtement fortement émissif au moins sur la totalité de la surface des dépôts.

Le fluxmètre radiatif, dans les différents modes de réalisation, peut être réalisé en tant que fluxmètre double face en disposant une bande continue avec ses dépôts de chaque côté d'un support commun, au moins les dépôts étant recouverts d'un revêtement fortement émissif sur les deux ou une seule face; en outre un support supplémentaire pour l'ensemble du fluxmètre peut être prévu.

Par ailleurs, on peut, dans tous les modes de réalisation, prévoir une couche d'une matière bonne conductrice de la chaleur sur la face du dispositif qui vient s'appliquer contre une paroi ou une surface à étudier.

Enfin il est avantageux d'associer à un fluxmètre radiatif, à simple ou à double face, selon l'invention, constituant fluxmètre principal, un second fluxmètre thermique de compensation avec une bande ou des bandes continues et des dépôts de même forme et dimension que la bande ou les bandes et les dépôts du fluxmètre principal, en prévoyant un montage tel que les effets des échanges thermiques convectifs dans les deux fluxmètres soient les mêmes et se compensent dans la force électromotrice globale obtenue à la sortie de l'ensemble des deux fluxmètres, cette force électromotrice globale étant alors une mesure exacte de l'intensité du flux radiatif qui frappe le fluxmètre combiné.

Le fluxmètre combiné peut être constitué en fait par deux fluxmètres radiatifs disposés côte à côte, de préférence imbriqués ou enchevêtrés, sur un même support, ou bien il peut être constitué par un fluxmètre mixte comportant, sur une bande continue conductrice commune, des dépôts recouverts d'un revêtement à pouvoir émissif élevé pour constituer un fluxmètre principal et des dépôts non revêtus d'un tel revêtement pour former un fluxmètre de compensation, ces deux sortes de dépôts étant de préférence disposés en alternance.

Un fluxmètre radiatif selon l'invention trouve de nombreuses applications dans le domaine thermique.

Suivant l'intensité et/ou le sens des échanges thermiques détectés entre une surface ou paroi et l'ambiance ou une autre surface ou paroi, un fluxmètre selon l'invention peut servir à commander un chauffage, notamment radiatif, en fonction par exemple des apports solaires en provenance du milieu extérieur.

On peut établir avec un fluxmètre radiatif selon l'invention le bilan radiatif et/ou thermique d'une paroi.

Un fluxmètre selon l'invention peut également servir à détecter un rayonnement thermique, par exemple à mesurer le rayonnement d'un four.

Comme il va de soi et comme il résulte d'ailleurs déjà de ce qui précède, l'invention ne se limite nullement à ceux de ses modes d'application et de réalisation qui ont été plus spécialement envisagés; elle en embrasse, au contraire, toutes les variantes.

Ainsi au lieu de prévoir, sur la bande continue conductrice ou sur les bandes continues conductrices, une rangée unique de dépôts conducteurs successifs, on peut prévoir deux ou plus de deux rangées parallèles de tels dépôts.

On pourrait également donner aux dépôts du fluxmètre radiatif de l'invention une des formes illustrées dans le brevet européen n° 0 030 499 précité.

REVENDICATIONS

1. Dispositif pour mesurer l'intensité d'un flux radiatif comportant en combinaison :

- un support mince (11, 21, 31) en une matière isolante;

- une bande continue allongée mince (12a, 12b, 12, 22, 22A, 32), en une première matière conductrice, l'une de ses faces étant fixée sur ledit support;

- une série de dépôts discontinus (13a, 13b, 13c, 23A, 33A, 13d), en une seconde matière conductrice, disposés successivement, dans la direction d'allongement (XX) de ladite bande, sur l'autre face de celle-ci, cette seconde matière conductrice ayant un pouvoir thermoélectrique différent de celui de la première matière conductrice et une plus grande conductivité électrique et ces dépôts étant plus minces que ladite bande; et

- des moyens pour déterminer la force électromotrice disponible aux extrémités de ladite bande continue allongée;

et caractérisé

- en ce que l'ensemble, constitué par un desdits dépôts et la portion associée de la bande continue sous-jacente formant un thermocouple élémentaire, présente, dans la direction transversale par rapport à la direction d'allongement (XX) de ladite bande, une largeur qui varie entre ses deux extrémités, dans la direction d'allongement de ladite bande, la variation de largeur étant dans le même sens pour les dépôts se succédant le long de ladite bande; et

- en ce qu'il comporte un revêtement (14, 14a, 14b, 24a, 24b, 24c, 34a) à forte émissivité recouvrant étroitement au moins lesdits dépôts successifs, au moins partiellement.

2. Dispositif selon la revendication 1, caractérisé en ce que la bande continue (12a) est constituée par une succession continue de triangles isocèles ou, à la limite, équilatéraux (12'a) en contact les uns avec les autres et dont les axes de symétrie sont alignés sur l'axe (XX) d'allongement de la bande et dont les sommets (12"a) disposés sur cet axe d'allongement sont dirigés dans le même sens si l'on considère la direction d'allongement de la bande et en ce que les dépôts (13a) sont constitués par une succession de trapèzes isocèles dont les grandes bases 13'a coïncident avec les grandes bases (12"'a) des triangles précités et dont les petites bases (13"a) sont disposées à distance des sommets précités.

3. Dispositif selon la revendication 1, caractérisé en ce que la bande continue (12b) est constituée par une succession ininterrompue d'unités (12'b) ayant la forme de la lettre T en contact entre elles et en ce que les dépôts discontinus (13b) ont aussi la forme de la lettre T, les axes de symétrie des "T" de la bande et des dépôts étant alignés sur l'axe (XX) d'allongement de la bande, les barres longitudinales (12"b; 13'b) des T étant dirigées dans le même sens si on considère la direction d'allongement de la bande et les barres longitudinales (13'b) des T des dépôts étant plus courtes que les barres longitudinales (12"b) des T de la bande continue.

4. Dispositif selon la revendication 1, caractérisé en ce que la bande continue (12) a une largeur constante et en ce que les dépôts discontinus (13c) ont la forme de U disposés symétriquement par rapport à l'axe (XX) d'allongement de la bande, les ouvertures (17c) des U étant dirigées dans le même sens si on considère la direction d'allongement de la bande.

5. Dispositif selon la revendication 1, caractérisé en ce que la bande continue (12) a une largeur constante, en ce que les dépôts discontinus ont la forme de rectangles (13d) de largeur constante et en ce qu'il comporte des trous ou évidements (C) qui découpent transversalement les dépôts et la bande continue sous-jacente, tous les évidements étant décalés, dans la direction d'allongement de la bande continue, dans le même sens par rapport au centre de chaque dépôt discontinu.

6. Dispositif selon l'une quelconque des revendications précédentes, caractérisé en ce qu'il comporte un revêtement (14) à forte émissivité recouvrant à la fois lesdits dépôts discontinus (13a, 13b, 13d) et les zones (16a, 16b) de la bande continue (12) non revêtues de dépôts.

7. Dispositif selon l'une quelconque des revendications 1 à 5, caractérisé en ce qu'il comporte un revêtement (14a, 14b, 24a, 24b, 24c, 34a) à forte émissivité couvrant uniquement lesdits dépôts (13c, 23A, 33A), au moins partiellement.

8. Dispositif selon la revendication 7, caractérisé en ce qu'il comporte un revêtement réfléchissant, c'est-à-dire à faible émissivité, sur les zones (16c, 26A) de la bande continue (12, 22A) non revêtues de dépôts.

9. Dispositif selon l'une quelconque des revendications précédentes, caractérisé en ce que la bande continue (12, 22, 22A, 32) est repliée pour avoir une configuration méandriforme.

10. Dispositif selon l'une quelconque des revendications précédentes, caractérisé en ce que la première matière conductrice formant la bande continue est l'alliage appelé "constantan" et en ce que la seconde matière conductrice formant les dépôts est le cuivre.

11. Dispositif selon l'une quelconque des revendications précédentes, caractérisé en ce que le revêtement à forte émissivité est constitué par une peinture mate noire.

12. Dispositif selon l'une quelconque des revendications 7 à 10, caractérisé en ce que les dépôts sont en cuivre et en ce que le revêtement à forte émissivité sur les dépôts est constitué par une pellicule d'oxyde de cuivre noir sur les dépôts, cette pellicule étant obtenue par oxydation superficielle du cuivre des dépôts en portant ceux-ci à haute température dans une atmosphère oxydante.

13. Dispositif selon l'une quelconque des revendications 8 à 12, caractérisé en ce que le revêtement réfléchissant à faible émissivité est réalisé par une pellicule d'aluminium ou une peinture à l'aluminium.

14. Dispositif selon l'une quelconque des revendications précédentes, caractérisé en ce que la face du dispositif à appliquer sur une surface ou paroi à étudier est recouverte d'une couche (15) en une matière très bonne conductrice de la chaleur pour réaliser une température uniforme moyenne sur cette face.

15. Dispositif selon l'une quelconque des revendications précédentes, caractérisé en ce qu'il comporte en outre une structure en "nid d'abeilles" (N) sur la face du dispositif recevant le flux radiatif au-dessus du revêtement (14, 14a,14b, 24a, 24b, 24c, 34a) à forte émissivité.

16. Dispositif selon l'une quelconque des revendications précédentes, caractérisé en ce qu'il comporte, contre chaque face du support (11; 21), une bande continue (12, 12'; 22A, 22'A) revêtue de dépôts (13c, 13'c; 23A, 23'A) avec le revêtement à fort pouvoir émissif sur au moins les dépôts d'une des faces.

17. Dispositif selon la revendication 16, caractérisé en ce qu'il comporte un support supplémentaire (11'; 21'), également en une matière isolante, qui est appliquée contre une de ses faces, à savoir celle qui doit être appliquée contre une surface ou paroi, alors que l'autre face reçoit le flux radiatif à mesurer, avec une couche (15; 25) conductrice de la chaleur, déposée sur la face du support supplémentaire qui n'est pas contre la partie active du dispositif.

18. Dispositif selon l'une quelconque des revendications précédentes, caractérisé en ce qu'il est associé à un fluxmètre de compensation analogue à bande continue et à dépôts, mais ceux-ci non recouverts de revêtements fortement émissifs, cette bande et ces dépôts ayant même forme et dimensions que la bande continue et les dépôts du dispositif formant fluxmètre principal, et ce fluxmètre de compensation mesurant les échanges thermiques convectifs auxquels est soumis le dispositif.

19. Dispositif avec fluxmètre de compensation, selon la revendication 18, caractérisé en ce que les bandes continues (22A, 22'A, d'une part, 22B, 22'B, d'autre part) avec les dépôts (23A, 23'A, d'une part, 23B, 23'B, d'autre part) du dispositif et du fluxmètre de compensation sont disposés sur un support isolant commun (21) en étant imbriquées l'une dans l'autre.

20. Dispositif avec fluxmètre thermique, selon la revendication 18, caractérisé en ce que le dispositif et le fluxmètre de compensation sont constitués à partir d'un support commun (31) et d'une bande continue commune (32) revêtue de dépôts alternés (33A, 33B) appartenant respectivement au dispositif et au fluxmètre de compensation, les dépôts couverts d'un revêtement (34a) à forte émissivité du dispositif alternant avec les dépôts sans un tel revêtement du fluxmètre de compensation et les deux types de dépôts alternés étant orientés en sens inverse en ce qui concerne la variation de la largeur, lorsqu'on considère la direction d'allongement (XX) de la bande continue commune (32).

21. Dispositif selon l'une quelconque des revendications 18 à 20, caractérisé en ce qu'il comporte des moyens à deux entrées recevant les forces électromotrices disponibles aux extrémités de la bande continue allongée du fluxmètre principal et du fluxmètre de compensation respectivement, ces moyens étant aptes à déterminer, et à fournir sur leurs deux sorties, deux signaux représentatifs respectivement du flux radiatif et du flux convectif reçus par le dispositif.

22. Dispositif selon la revendication 19, caractérisé en ce que les évidements entre les branches de l'U des dépôts discontinus (23A, 23B) de la face supérieure et des dépôts discontinus (23'A, 23'B) de la face inférieure sont d'une longueur, dans le sens d'allongement de la bande continue (26A), telle qu'une partie de la portion interne de ces évidements de la face supérieure vient chevaucher une partie de la portion interne des évidements correspondant de la face inférieure.

22. Dispositif selon la revendication 19, caractérisé en ce que les évidements entre les branches de l'U des dépôts discontinus (23A,23B) de la face supérieure et des dépôts discontinus (23'A,23'B) de la face inférieure sont d'une longueur, dans le sens d'allongement de la bande continue (26A), telle qu'une partie de la portion interne de ces évidements de la face supérieure vient chevaucher une partie de la portion interne des évidements correspondants de la face inférieure

23. Dispositif selon l'une quelconque des revendications précédentes, caractérisé en ce que le support mince (11,21,31) en matière isolante est réalisé en une céramique.

24. Dispositif selon la revendication 23, caractérisé en ce que ladite céramique est une pâte céramique à base d'alumine qui a été soumise à une cuisson après application.

0246951

FIG.1.

FIG.2.

FIG.3.

FIG.4.

FIG.5.

FIG.6.

FIG.10.

0246951

FIG.7.

0246951

FIG.8.

FIG.9.

# FIG.11.

# FIG.12.

0246951

FIG.13.

# FIG.14.

0246951

FIG.15.

## Office européen des brevets

# RAPPORT DE RECHERCHE EUROPEENNE

EP 87 40 1060

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| D,A | WO-A-8 402 037 (ANVAR) <br> * Figures 1,2; revendications 1,4,5,9,10 * & FR-A-2 536 536 | 1,10 | H 01 L 35/08 <br> G 01 J 5/12 |
| A | US-A-3 607 445 (HINES) <br> * Figure 4; colonne 5, lignes 14-18 * | 1,10 | |
| A | JOURNAL OF PHYSICS E. SCIENTIFIC INSTRUMENTS, vol. 13, no. 8, août 1980, pages 860-865, The Institute of Physics, Londres, GB; P. THERY et al.: "Etude et caractérisation d'un nouveau fluxmètre calorifique" * Figure 2 * | 1,10 | |
| D,A | EP-A-0 030 499 (ANVAR) <br> * Revendications 1,5,8 * | 1,9,10 | **DOMAINES TECHNIQUES RECHERCHES (Int Cl 4)** <br><br> H 01 L <br> G 01 J |

Le présent rapport de recherche a été établi pour toutes les revendications

| Lieu de la recherche | Date d'achèvement de la recherche | Examinateur |
|---|---|---|
| LA HAYE | 03-08-1987 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82